Europäisches Patentamt

European Patent Office

Office européen des brevets

(19)

(11) **EP 1 107 009 A1**

(12) **DEMANDE DE BREVET EUROPEEN**

(43) Date de publication:
**13.06.2001 Bulletin 2001/24**

(51) Int Cl.⁷: $G01R\ 19/00$, G01R 15/00, G01R 1/20

(21) Numéro de dépôt: **00403296.7**

(22) Date de dépôt: **24.11.2000**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **09.12.1999 FR 9915542**

(71) Demandeur: **SAGEM SA**
**75016 Paris (FR)**

(72) Inventeur: **Ribes, Laurent**
**95520 Osny (FR)**

(74) Mandataire: **Fort, Jacques**
**CABINET PLASSERAUD**
**84, rue d'Amsterdam**
**75440 Paris Cedex 09 (FR)**

(54) **Appareil de mesure de l'intensité du courant dans un conducteur**

(57)     L'appareil de mesure du courant traversant un conducteur comporte un amplificateur différentiel (10,14) de tension muni d'entrées de raccordement au conducteur en deux points espacés de ce dernier, constituant les extrémités d'un tronçon (12), et un circuit de conversion de la tension de sortie de l'amplificateur en une valeur d'intensité. Le circuit de conversion incorpore une table d'étalonnage mémorisée sous forme numérique.

FIG.1.

EP 1 107 009 A1

## Description

La présente invention a pour objet un appareil de mesure du courant qui parcourt un conducteur électrique, qu'il soit continu ou alternatif.

La solution classique pour mesurer un tel courant, notamment lorsqu'il s'agit d'un courant continu, consiste à couper le câble, à interposer entre les tronçons une résistance de valeur connue et à mesurer la différence de potentiel aux bornes de la résistance.

Cette solution oblige à couper le câble et à insérer un élément résistant entre les tronçons.

L'invention vise à éviter cette nécessité et utilise pour cela les performances récentes des amplificateurs de tension et la possibilité de traiter numériquement les données analogiques fournies par un tel amplificateur.

Dans ce but, elle propose un appareil suivant la revendication 1.

Dans le cas d'un courant continu, le circuit fournit directement l'intensité. Dans le cas d'un courant alternatif, un composant de conversion est prévu. L'invention est particulièrement adaptée à la mesure des courants forts.

Un tel appareil de mesure permet d'éviter tout sectionnement du câble et toute incidence du raccordement qui est indispensable dans les approches antérieures.

La mesure est fondée sur la relation qui existe entre la tension Vs de sortie de l'amplificateur et le courant I qui traverse le conducteur :

$$Vs = (1 + \varepsilon) A. Vc$$

avec $Vc = R.I$

Où

I est le courant dans le conducteur
R est la résistance du tronçon de conducteur
$\varepsilon$ désigne un coefficient dépendant des erreurs statiques, toujours très inférieur à 1 et mémorisé,
A est le coefficient d'amplification courant /tension.

Lorsque la température du conducteur est susceptible de varier suffisamment pour avoir une influence appréciable sur la résistivité et donc sur la résistance du tronçon, un capteur de température et un calcul de correction tenant compte du coefficient de variation en fonction de la température sont prévus.

La mesure des erreurs statiques peut s'effectuer en atelier lorsque l'appareil de mesure est monté de façon définitive sur le conducteur. Il est également possible d'effectuer un étalonnage périodique en prévoyant dans l'appareil un générateur de courant d'intensité connue à une fréquence permettant de séparer ce courant d'étalonnage du courant à mesurer, qui peut être continu ou alternatif. La mesure de la tension provenant du passage d'un courant connu, provenant d'un générateur sans dérive en température, permet de déterminer les facteurs d'étalonnage et éventuellement de correction en fonction de la température requis. Un capteur de température n'est plus nécessaire si l'étalonnage à l'aide du générateur de courant est effectué à une fréquence suffisante ou avant chaque mesure.

Avantageusement les circuits de l'appareil constituent un ensemble surmoulé sur le tronçon de conducteur, préalablement dénudé pour permettre les raccordements.

Les caractéristiques ci-dessus, ainsi que d'autres, apparaîtront mieux à la lecture de la description qui suit de modes particuliers de réalisation, donnés à titre d'exemples non limitatifs. La description se réfère aux dessins qui l'accompagnent, dans lesquels :

- la figure 1 est un schéma faisant apparaître les paramètres qui interviennent dans la mesure ;
- la figure 2 montre une constitution matérielle possible de l'appareil.

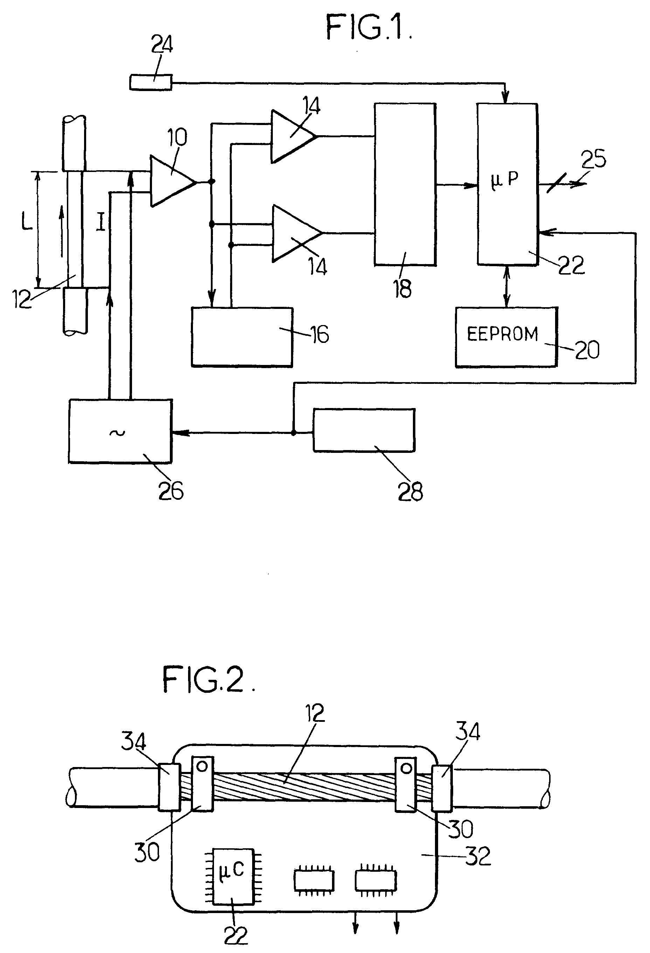

L'appareil montré en figure 1 sous forme schématique comporte un préamplificateur différentiel 10 dont les entrées sont reliées au conducteur de part et d'autre d'un tronçon 12 de longueur L. Dans le mode de réalisation schématisé, ce préamplificateur est suivi de deux amplificateurs 14 qui seront mis l'un ou l'autre fonction de l'intensité du courant pour augmenter la plage de mesure. Ce nombre n'est pas limitatif. Le nombre d'amplificateurs dépend de la plage de mesure et aussi de la possibilité ou non du courant de s'inverser. La sélection peut être faite par un circuit de sélection 16 en fonction de la tension de sortie du préamplificateur 10. Un étage analogique de sortie de sortie 18 alimente un microcontrôleur 22 comportant un convertisseur analogique-numérique d'entrée et associé à une mémoire 20 destinée à stocker la table d'étalonnage. Une source d'alimentation stabilisée en tension, non représentée, est reliée aux composants actifs.

La résistance R du tronçon de conducteur peut s'écrire :

$$R = \rho_0 (1 + \alpha \Delta\theta)L/S$$

où

$\rho_0$ est la résistivité à une température de calibrage, par exemple 20°C,
S est la section droite
$\alpha$ est le coefficient moyen de température dans la plage de fonctionnement envisagé,
$\Delta\theta$ est la différence entre la température de mesure et la température de calibrage.

Les variations de la longueur L du câble sont généralement négligeables dans la plage de mesure prévue.

Le courant Ic dans le câble est alors lié à la tension de sortie Vs après amplification nominale A par la relation :

$$Vs = (1 + \varepsilon)\ A.Ic\ (1 + \alpha.\Delta\theta).R_0 \qquad (1)$$

où $R_0$ est la résistance à la température de référence et $\varepsilon$ l'erreur statique, mémorisée sous forme de table, car susceptible de dépendre de Vs. La valeur de Ic s'écrit donc :

$$Ic = Vs/[(1 + \varepsilon)\ A(1 + \alpha.\Delta\theta)]\ R_0 \qquad (2)$$

Pour permettre au micro-contrôleur 22 d'effectuer une correction de température, l'appareil comporte un capteur de température 24 placé à proximité du tronçon 12. La température ainsi mesurée, mise sous forme numérique, est prise en compte par le micro-contrôleur pour calculer le terme correctif $1 + \alpha.\Delta\theta$ de la formule (2) ci-dessus.

En général, l'appareil sera monté de façon permanente sur un tronçon de câble et le calibrage effectué en usine. Cela implique de mémoriser $R_0$ et la valeur moyenne $\alpha$ du coefficient de température pour la plage de mesure envisagée. Pour le cuivre par exemple, le coefficient moyen de température est de 0,004 en moyenne dans la plage allant de -20°C à 60°C. Dans le cas fréquent d'un conducteur en cuivre, les variations de longueur dans cette plage sont négligeables, car le coefficient de dilatation linéaire est alors de $1,7 \times 10^{-5}$ mm/°C.

Les erreurs statiques $\varepsilon$ changent généralement peu en fonction de la température de sorte qu'il suffira de mesurer sa valeur pour une série d'intensités suffisamment rapprochées et de les mémoriser. Cette opération peut s'effectuer en faisant passer dans le tronçon des intensités de courant bien déterminées, à une température stabilisée et en calculant à chaque fois la valeur correspondante de $\varepsilon$.

Lors de chaque mesure, le micro-contrôleur 22 recherche, en fonction de Vs, la valeur appropriée de $\varepsilon$, éventuellement par interpolation entre les valeurs stockées dans la mémoire 20. Il effectue également le calcul du facteur de correction en fonction de la température $1 + \alpha.\Delta\theta$ et fournit, sur sa sortie 25, l'intensité sous forme numérique. Cette sortie est par exemple appliquée au circuit d'attaque d'un afficheur. Elle peut également être utilisée comme entrée d'un organe de régulation ou de contrôle. Une application importante est alors la mesure du courant de batterie, notamment sur un véhicule muni d'un alternateur-démarreur.

Dans une variante de réalisation, l'appareil comporte également un générateur de courant 26 relié au tronçon de câble de façon à y faire circuler un courant déterminé, ou un courant présentant une séquence de paliers déterminée. Un composant 28 permet de donner à l'appareil deux modes de fonctionnement. L'un des deux modes est un calibrage, au cours duquel le générateur fournit une tension alternative à une fréquence notablement différente de celle qui est à mesurer dans le conducteur, par exemple de l'ordre du kHz dans le cas d'un appareil destiné à mesurer l'intensité d'un courant continu ou d'un courant à 50 Hz. Lorsque l'étalonnage doit s'effectuer alors qu'un courant parcourt le conducteur, un filtre fréquentiel doit pouvoir être interposé à l'entrée du pré-amplificateur 10.

Le composant 28 peut être à commande manuelle, pour autoriser un calibrage à la demande, ou constitué par un séquenceur.

L'appareil peut avoir la constitution matérielle montrée en figure 2. Le conducteur 12 est dénudé sur une portion qui reçoit des brides 30 de prise de tension. Une carte 32 porte les composants actifs du système. Aux extrémités du tronçon, l'isolant du câble est relié à la carte par des joints surmoulés 34. Un couvercle non représenté peut fermer l'appareil et il peut porter un organe d'affichage.

## Revendications

1. Appareil de mesure du courant traversant un conducteur, comportant un amplificateur différentiel (10) de tension muni d'entrées de raccordement au conducteur en deux points espacés de ce dernier, constituant les extrémités d'un tronçon (12), et un circuit de conversion de la tension de sortie de l'amplificateur en une valeur d'intensité, le dit circuit incorporant un micro-contrôleur (22) associé à une mémoire programmable (20) de stockage d'une table d'étalonnage mémorisée sous forme numérique.

2. Appareil suivant la revendication 1, caractérisé en ce qu'il comporte de plus un capteur de température (24) et des moyens de correction tenant compte du coefficient de variation de la résistivité en fonction de la température, incorporant le dit micro-contrôleur (22).

3. Appareil suivant la revendication 1 ou 2, caractérisé en ce que la mémoire contient une table de correction des erreurs statiques en fonction de l'intensité.

4. Appareil suivant la revendication 1, 2 ou 3, caractérisé en ce qu'il comporte de plus un générateur (26) de courant d'étalonnage d'intensité connue, à une fréquence permettant de séparer ce courant d'étalonnage du courant à mesurer, et des moyens de détermination ou de correction de la table d'étalonnage à partir de la tension mesurée à la fréquence du courant d'étalonnage.

**5.** Appareil suivant l'une quelconque des revendications précédentes, caractérisé en ce le circuit de conversion comprend, en aval de l'amplificateur différentiel, au moins deux amplificateurs (14) mis sélectivement en service suivant l'intensité du courant.

**6.** Application d'un appareil suivant l'une quelconque des revendications précédentes à la mesure du courant de batterie sur un véhicule muni d'un alternateur - démarreur.

# FIG.1.

# FIG.2.

**Office européen des brevets**

# RAPPORT DE RECHERCHE EUROPEENNE

Numéro de la demande

EP 00 40 3296

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 4 584 525 A (HARNDEN JR JOHN D ET AL) 22 avril 1986 (1986-04-22) * revendication 1 * ----- | 1,2 | G01R19/00 G01R1/20 |

**DOMAINES TECHNIQUES RECHERCHES (Int.Cl.7)**

G01R

Le présent rapport a été établi pour toutes les revendications

| Lieu de la recherche | Date d'achèvement de la recherche | Examinateur |
|---|---|---|
| LA HAYE | 1 février 2001 | Six, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 00 40 3296

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-02-2001

| Document brevet cité au rapport de recherche | Date de publication | Membre(s) de la famille de brevet(s) | Date de publication |
|---|---|---|---|
| US 4584525 A | 22-04-1986 | AUCUN | |